# EUROPÄISCHE PATENTSCHRIFT

(11) **EP 2 119 327 B1**
(45) Veröffentlichungstag und Bekanntmachung des Hinweises auf die Patenterteilung: **26.10.2011**
(21) Anmeldenummer: 08700293.7
(22) Anmeldetag: 30.01.2008
(51) Int. Cl.: H05K 1/02, H05K 3/46

(54) **VERFAHREN ZUM ENTFERNEN EINES TEILBEREICHS EINER FLÄCHIGEN MATERIALSCHICHT**
METHOD FOR REMOVING A PART OF A PLANAR MATERIAL LAYER
PROCÉDÉ POUR ENLEVER UNE PORTION D'UNE COUCHE DE MATIÈRE PLANE

(30) Priorität: 16.02.2007 AT 10007 U; 03.12.2007 AT 72807 U
(43) Veröffentlichungstag der Anmeldung: 18.11.2009
(73) Patentinhaber: AT & S Austria Technologie & Systemtechnik Aktiengesellschaft, 8700 Leoben-Hinterberg (AT)
(72) Erfinder: WEIDINGER, Gerald, A-4600 Wels (AT); LEITGEB, Markus, A-8793 Trofaiach (AT); STAHR, Johannes, A-8600 Bruck (AT); WEICHSLBERGER, Günther, A-8044 Graz (AT); ZLUC, Andreas, A-8700 Leoben (AT)
(74) Vertreter: Miksovsky, Alexander
(86) Internationale Anmeldenummer: PCT/AT2008/000027
(87) Internationale Veröffentlichungsnummer: WO 2008/098269

(56) Entgegenhaltungen:
- DE-C1- 4 003 344
- DE-U1- 20 221 189
- US-A- 5 645 673
- US-B1- 6 245 382

## Beschreibung

Die vorliegende Erfindung bezieht sich auf ein Verfahren zum Entfernen eines Teilbereichs einer im wesentlichen flächigen Materialschicht, welche in einem Verbindungsvorgang mit wenigstens einer weiteren, im wesentlichen flächigen Materialschicht verbunden wird, wobei im Bereich der nachfolgenden Entfernung des Teilbereichs ein von einer unmittelbaren Verbindung zwischen den Materialschichten freigestellter Bereich durch Aufbringen eines ein Anhaften der zu verbindenden Materialschichten verhindernden Materials vorgesehen wird, wobei die miteinander zu verbindenden, im wesentlichen flächigen Materialschichten von Schichten bzw. Lagen einer mehrlagigen Leiterplatte gebildet werden. Darüber hinaus bezieht sich die vorliegende Erfindung auf eine Verwendung eines derartigen Verfahrens im Zusammenhang mit einer Herstellung einer mehrlagigen Leiterplatte.

Ein derartiges Verfahren sowie eine derartige mehrlagige Struktur in Form einer mehrlagigen Leiterplatte ist beispielsweise aus der DE 40 03 344 C bekannt, wobei darauf abgezielt wird, ein einfaches Verfahren zur Herstellung einer starr-flexiblen Leiterplatte zur Verfügung zu stellen.

Darüber hinaus ist beispielsweise aus der US 6,245,382 B ein Verfahren zur Herstellung eines Schutzfilms bekannt geworden, welcher sicher und zuverlässig an einem Polymersubstrat anhaften soll.

Weiters ist aus der US-A 3 577 915 ein Druckverfahren für ein Siebdrucken von thermoplastischer Tinte bekannt geworden, welche unter anderem Polyethylen enthält.

Wenn auch die nachfolgende Beschreibung auf die Herstellung einer mehrlagigen Leiterplatte Bezug nimmt, so ist anzumerken, dass das erfindungsgemäße Verfahren in unterschiedlichsten Anwendungsbereichen zum Einsatz gelangen kann wobei darauf abgezielt wird, aus einer im wesentlichen flächigen Materialschicht einen Teilbereich nach einer Verbindung mit wenigstens einer weiteren im wesentlichen flächigen Materialschicht zu entfernen. Allgemein ist die vorliegende Erfindung im Zusammenhang mit mehrlagigen Strukturen einsetzbar, bei welchen nach einer Herstellung einer mehrlagigen Struktur ein Teilbereich abgezogen bzw. eine der Schichten bzw. Lagen entfernt werden soll. In diesem Zusammenhang sind beispielsweise aufwendige Verfahren und Konstruktionen bekannt, bei welchen insbesondere durch eine Vorkonfektionierung wenigstens einer für eine Verbindung der miteinander zu verbindenden Materialschichten eingesetzten Verbindungsschicht und entsprechend hohem Arbeitsaufwand und entsprechend hohem Aufwand für eine nachfolgende ordnungsgemäße Ausrichtung bzw. Registrierung der miteinander zu verbindenden Materialschichten darauf abgezielt wird, nach einer Verbindung derartiger Materialschichten Teilbereiche freizulegen bzw. zu entfernen. Die im wesentlichen flächigen Materialschichten können hiebei aus beispielsweise papier- oder kartonartigen, miteinander zu verbindenden Schichten bzw. Elementen, im wesentlichen platten- bzw. blattförmigen Elementen, wie beispielsweise Folien, Blechen oder metallischen Platten oder ähnlichen gebildet werden. Im Zusammenhang mit einer Verbindung von im wesentlichen flächigen bzw. plattenartigen Materialien ist es insbesondere für eine gegebenenfalls erforderliche nachträgliche Entfernung wenigstens eines Teilbereichs beispielsweise bekannt, Folien, welche Hafteigenschaften aufweisen, entsprechend vorzukonfektionieren, so dass Teilbereiche der Folien, welche während des Verbindungsvorgangs ein Anhaften der miteinander zu verbindenden Materialschichten bereitstellen sollen, mit Ausnehmungen versehen werden. Alternativ können neben im wesentlichen vollflächigen Klebefolien entsprechend dem nachträglich zu entfernenden Teilbereich vorkonfektionierte Trennfolien eingesetzt werden. Es ist unmittelbar einsichtig, dass eine derartige Vorkonfektionierung derartiger Verbindungsfolien bzw. Klebefolien und/oder Trennfolien mit entsprechend hohem Aufwand verbunden ist und darüber hinaus entsprechend hohe Anforderungen an eine Registrierung bzw. Ausrichtung der miteinander zu verbindenden Materialschichten stellt.

Im Zusammenhang mit einer Herstellung von mehrlagigen elektronischen Bauteilen, insbesondere mehrlagigen Leiterplatten führt die in den letzten Jahren an Komplexität zunehmende Konstruktion derartiger elektronischer Bauteile allgemein zu einem Erhöhen der Anzahl von Verbindungs- bzw. Anbindungspunkten von aktiven Bauteilen zu Bestandteilen einer Leiterplatte, wobei mit einer zunehmenden Reduktion der Größe gleichzeitig eine Reduktion des Abstands zwischen derartigen Anbindungspunkten vorzusehen ist. Im Zusammenhang mit der Herstellung von Leiterplatten wurde hiebei beispielsweise eine Entflechtung von derartigen Verbindungs- bzw. Anbindungspunkten von Bauteilen über Mikrovias über mehrere Leiterplattenlagen hinweg in sogenannten High Density Interconnects (HDI) vorgeschlagen.

Neben einer zunehmenden Erhöhung der Komplexität des Designs bzw. der Konstruktion von Leiterplatten, beispielsweise im Zusammenhang mit einer Ausbildung von Kavitäten bzw. Hohlräumen und einer damit einhergehenden Miniaturisierung sind zusätzliche Anforderungen im Hinblick auf falz- bzw. biegefähige Verbindungen in einer Leiterplatte entstanden, welche zur Entwicklung einer Hybridtechnik und zum Einsatz sogenannter starr-flexibler Leiterplatten führte. Derartige starr-flexible Leiterplatten, welche aus starren Bereichen bzw. Teilbereichen der Leiterplatte sowie derartige starre Bereiche verbindenden, flexiblen Bereichen bestehen, erhöhen die Zuverlässigkeit, bieten weitere bzw. zusätzliche Möglichkeiten einer Freiheit des Designs bzw. der Konstruktion und ermöglichen weitere Miniaturisierungen.

Zur Herstellung derartiger starr-flexibler Leiterplatten sind zwischen starren und flexiblen Bereichen einer Leiterplatte diese entsprechenden Verbindungsschichten aus einem dielektrischen Material vorzusehen, wobei eine Anordnung von entsprechenden blattförmigen Schichten bzw. Folien, welche beispielsweise durch eine Wärmebehandlung zu einer Verbindung von miteinander zu verbindenden, starren und flexiblen Bereichen einer Leiterplatte führen, üblicherweise vergleichsweise dicke Schichten ergibt. Derartige dicke Schichten wirken nicht nur einer beabsichtigten Miniaturisierung bei der Herstellung von mehrlagigen Leiterplatten entgegen, sondern führen auch zu einem Verlust an Registriergenauigkeit für nachfolgende Laser-Bohrlochgeometrien zur Ausbildung der Mikrovias und entsprechend eng beabstandeter Verbindungs- bzw. Anbindungsstellen. Derartige dicke, bekannte Schichten aus nicht-leitendem Material bzw. Dielektrikumschichten führen darüber hinaus zu zusätzlichen Verarbeitungs- bzw. Prozeßschritten und/oder zu einem aufwendigeren Design zur Herstellung der erforderlichen Verbindungen zwischen den starren und flexiblen Bereichen der Leiterplatten, da insbesondere eine entsprechende Vorkonfektionierung bzw. Formatierung entsprechend der nachfolgenden Durchtrennung der starren Bereiche der Leiterplatte vorzusehen ist.

Die vorliegende Erfindung zielt darauf ab, unter Vermeidung der Probleme des oben genannten Standes der Technik insbesondere im Hinblick auf eine Vorkonfektionierung bzw. Formatierung von Verbindungselementen bzw. -folien ein Verfahren sowie eine mehrlagige Struktur der eingangs genannten Art dahingehend weiterzubilden, dass derartige mehrlagige Strukturen mit einem vereinfachten Verfahren hergestellt werden können, wobei insbesondere auf aufwendige Vorbereitungsschritte verzichtet werden kann bzw. diese entsprechend reduziert werden können.

Zur Lösung dieser Aufgaben ist ein Verfahren der eingangs genannten Art im wesentlichen **dadurch gekennzeichnet, dass** das ein Anhaften verhindernde Material einen derart hohen Erweichungspunkt bzw. Fliesspunkt aufweist, so dass es während eines Laminiervorgangs zu einem Härten der darüber hinaus eingesetzten Kleberlagen kommt und es bei weiterer Erhöhung der Temperatur während des Verbindungsvorgangs bzw. Pressvorgangs zu einer Verflüssigung des ein Anhaften verhindernden Materials kommt, und dass das ein Anhaften verhindernde Material als wachsartige Paste in Form einer Dispersion in einem Lösungsmittel aufgebracht wird und wobei das ein Anhaften verhindernde Material weiter eine Trennkomponente und ein Bindemittel enthält.

Da erfindungsgemäß im Bereich der nachfolgenden Durchtrennung bzw. Entfernung eines Teilbereichs ein von einer Verbindung freigestellter Bereich vorgesehen wird, wodurch insbesondere ein Anhaften des in weiterer Folge zu entfernenden Teilbereichs an der anzuordnenden weiteren Materialschicht verhindert wird, kann zuverlässig eine nachträgliche Durchtrennung der den zu entfernenden Teilbereich aufweisenden Materialschicht ohne Einhaltung von überaus genauen Toleranzen für die Durchführung des Durchtrennungsschritts im Hinblick auf die Tiefe der Durchtrennung zur nachfolgenden Entfernung des Teilbereichs durchgeführt werden. Darüber hinaus wird durch das Vorsehen eines von einer Verbindung freigestellten Bereichs ermöglicht, insbesondere auf eine Vorkonfektionierung und/oder Formatierung von eine Verbindung ermöglichenden Schichten im Bereich der nachfolgenden Durchtrennung und Entfernung des Teilbereichs zu verzichten, so dass Vorbereitungsschritte für die Herstellung bzw. Vorbereitung der anzuordnenden bzw. zu verbindenden Materialschichten und einer zur Verbindung heranzuziehenden Schicht vereinfacht werden können. Aufgrund der Tatsache, dass im Bereich der nachfolgenden Durchtrennung bzw. Entfernung eines Teilbereichs auf eine Vorkonfektionierung einer Haft- bzw. Verbindungslage bzw. anzuordnenden Schicht verzichtet werden kann, kann darüber hinaus auch mit dünnen bzw. dünneren derartigen Zwischenschichten bzw. Verbindungslagen aus einem ein Anhaften verhindernden Material zwischen den miteinander zu verbindenden Metallschichten das Auslangen gefunden werden. Es können somit erfindungsgemäß im wesentlichen vollflächige Materialschichten zum Einsatz gelangen, wobei der ein Anhaften verhindernde Bereich zur Ausbildung der Freistellung einfach aufgebracht bzw. vorgesehen werden kann.

Im Zusammenhang mit der Herstellung einer Leiterplatte läßt sich insbesondere eine Miniaturisierung einer derartigen Leiterplatte und insbesondere einer starr-flexiblen Leiterplatte durch eine Minimierung der gesamten herzustellenden Leiterplatte erzielen, wobei auch Probleme, wie sie oben im Zusammenhang mit dem bekannten Stand der Technik betreffend eine Registriergenauigkeit bei Vorsehen von dicken Schichten bei Erfordernis einer Konfektionierung bzw. Formatierung von Zwischenlagen auftreten, zuverlässig vermieden werden können.

Zur Ausbildung eines von einer Verbindung zwischen den miteinander zu verbindenden Materialschichten im Bereich des nachträglich zu entfernenden Teilbereichs vorgesehenen, freigestellten Bereichs ist erfindungsgemäß vorgesehen, dass im Bereich der nachfolgenden Entfernung des Teilbereichs eine wachsartige Paste zwischen den miteinander zu verbindenden Materialschichten aufgebracht wird. Eine derartige wachsartige Paste läßt sich in einfacher und zuverlässiger Weise entsprechend präzise gemäß der nachfolgenden Durchtrennung bzw. Entfernung des Teilbereichs an bzw. auf einer der miteinander zu verbindenden Materialschichten zuverlässig und präzise aufbringen, so dass bei einer entsprechend vereinfachten Verfahrensführung nach einer Verbindung der miteinander zu verbindenden Materialschichten der Teilbereich in einfacher Weise entfernt werden kann, da im Bereich des nachträglich zu entfernenden Teilbereichs durch Vorsehen des ein Anhaften verhindernden Materials in Form einer wachsartigen Paste ein entsprechend freigestellter Bereich bzw. Bereich frei von einer anhaftenden Verbindung zwischen den Materialschichten zur Verfügung gestellt wird.

Derartige wachsartige Pasten können für eine einfache Verarbeitbarkeit, beispielsweise in Form einer Mikrodispersion in polaren oder unpolaren, organischen Lösungsmitteln aufgebracht werden.

Zur Erzielung des gewünschten Trenneffekts durch ein Freistellen durch ein Aufbringen eines ein Anhaften verhindernden Materials, wie dies oben ausgeführt ist, kann das ein Anhaften verhindernde Material einen Erweichungs- bzw. Fließpunkt von wenigstens 100 °C, insbesondere wenigstens 120 °C aufweisen. Durch einen derartigen hohen Erweichungs- bzw. Schmelzpunkt der Schicht aus einem ein Anhaften verhindernden Material kommt es erfindungsgemäß bei der Herstellung einer Leiterplatte während eines Laminiervorgangs zu einem Härten der darüber hinaus eingesetzten Kleberlagen und bei weiterer Erhöhung der Temperatur während des Verbindungs- bzw. Preßvorgangs zur einer Verflüssigung des ein Anhaften verhindernden Materials, wodurch sichergestellt wird, dass die durch das ein Anhaften verhindernde Material für die nachträgliche Entfernung des Teilbereichs erforderliche Freistellung zuverlässig erhalten bleibt. Das ein Anhaften verhindernde Material verhindert während des Verbindungsvorgangs durch Ausbildung einer flüssigen Schicht im nachträglich zu entfernenden Teilbereich eine vollflächige Verbindung, beispielsweise Verklebung der miteinander zu verbindenden Materialschichten.

Für ein besonders einfaches und zuverlässiges Verarbeiten des ein Anhaften verhindernden Materials wird erfindungsgemäß darüber hinaus vorgeschlagen, dass das ein Anhaften verhindernde Material eine Trennkomponente, ein Bindemittel und ein Lösungsmittel enthält. Die Trennkomponente stellt sicher, dass ein Anhaften in dem Bereich des nachfolgend zu entfernenden Teilbereichs zwischen den zu verbindenden Materialschichten zuverlässig verhindert wird. Das Bindemittel dient insbesondere dazu, um das ein Anhaften verhindernde Material während des Verbindungsvorgangs auf der Unterlage bzw. einer der miteinander zu verbindenden Materialschichten zu fixieren und eine Rheologie einzustellen, dass ein einwandfreies und problemloses Aufbringen ermöglicht wird. Als bevorzugtes Bindemittel kann beispielsweise Ethylzellulose verwendet werden. Darüber hinaus migriert bzw. wandert ein derartiges Bindemittel beispielsweise in das Material einer daran anschließenden flächigen Materialschicht, wodurch die Trennwirkung bzw. die Wirkung einer Verhinderung eines Anhaftens weiter verbessert wird. Das Lösungsmittel dient beispielsweise dazu, um das ein Anhaften verhindernde Material entsprechend einfach und zuverlässig zu verarbeiten.

Für ein besonders einfaches und positionsgenaues Aufbringen des von einer Verbindung freigestellten Bereichs wird gemäß einer weiters bevorzugten Ausführungsform vorgeschlagen, dass das ein Anhaften verhindernde Material durch ein Druckverfahren, insbesondere durch Siebdruck, Schablonendruck, Offsetdruck, Flexodruck, Tampondruck, Tintenstrahldruck oder dgl. aufgebracht wird und gegebenenfalls einem nachfolgenden Trocknungs- und/oder Härtverfahren unterworfen wird.

Zur Bereitstellung eines entsprechend leicht und zuverlässig einsetzbaren und verarbeitbaren, ein Anhaften der zu verbindenden Materialschichten verhindernden Materials kann das ein Anhaften verhindernde Material einen Polaritätsunterschied zu den daran anschließenden, im wesentlichen flächigen Materialschichten aufweisen. Die Verhinderung eines Anhaftens bzw. die Trennwirkung basiert im wesentlichen auf der Unverträglichkeit sowie dem Polaritätsunterschied zwischen dem Material der daran anschließenden, im wesentlichen flächigen Materialschichten und dem ein Anhaften verhindernden Material. In diesem Zusammenhang sollte für das ein Anhaften verhindernde Material besonders bevorzugt eine möglichst unpolare Verbindung eingesetzt werden, wobei beispielsweise Wachse natürlichen oder synthetischen Ursprungs diesen Zweck erfüllen.

In diesem Zusammenhang wird gemäß einer weiters bevorzugten Ausführungsform vorgeschlagen, dass das ein Anhaften verhindernde Material Kohlenwasserstoffwachse und -öle, Wachse und Öle auf Basis von Polyethylen- oder Polypropylenverbindungen, Wachse und Öle auf Basis von organischen Polyfluorverbindungen, Estern von Fettsäuren und Alkoholen oder Polyamiden, siliziumorganische Verbindungen und/oder Mischungen davon enthält. Derartige Wachse und Öle sind entsprechend dem Einsatzzweck in unterschiedlichen Ausführungsformen und mit unterschiedlichen chemischen und physikalischen Eigenschaften in großer Anzahl verfügbar, so dass sie entsprechend den miteinander zu verbindenden Materialschichten auswählbar sind. Kohlenwasserstoffwachse und -öle können hiebei von synthetischem oder natürlichem Ursprung, wie beispielsweise Paraffine sein. Neben insbesondere synthetischen Wachsen und Ölen auf Basis von Polyethylen- oder Polypropylenverbindungen können auch Modifikationen dieser Produktgruppen eingesetzt werden. Betreffend synthetische Wachse und Öle auf Basis von Polyfluor-organischen Verbindungen bzw. organischen Polyfluorverbindungen kann beispielsweise PTFE genannt werden. Wachse und Öl auf Basis von Estern von Fettsäuren und ein- oder mehrwertige Alkohole können synthetischen oder natürlichen Ursprungs sein, wie beispielsweise Palmitin- oder Stearinsäurederivate, Carnaubawachs oder dgl. Betreffend siliziumorganische Verbindungen können beispielsweise Silikon und Silikonöl genannt werden.

Zur Erleichterung der Aufbringung und Handhabung insbesondere der miteinander zu verbindenden Materialschichten wird darüber hinaus vorgeschlagen, dass das ein Anhaften verhindernde Material mit anorganischen und/oder organischen Füllstoffen und Additiven versehen wird.

Durch Vorsehen eines vergleichsweise hohen Schmelzpunkts für das ein Anhaften verhindernde Material und Bereitstellen des Lösungsmittels, welches beispielsweise einen Siedepunkt von etwa 200 °C aufweist, wird sichergestellt, dass während einer Aufbringung des Anhaften verhindernden Materials keine Probleme beispielsweise im Hinblick auf eine vorzeitige Trocknung entstehen. Darüber hinaus wird durch einen derartigen Siedepunkt sichergestellt, dass bei einer weiteren Erhöhung der Temperatur das Lösungsmittel im wesentlichen vollständig entfernt wird bzw. abgedampft wird.

Zur Erzielung gewünschter, geringer Schichtstärken unter Aufrechterhaltung der erfindungsgemäß vorgesehenen Freistellung bzw. Verhinderung eines Anhaftens wird gemäß einer weiters bevorzugten Ausführungsform vorgeschlagen, dass das ein Anhaften verhindernde Material, insbesondere die Paste, in einer Schichtstärke von weniger als 25 µm, insbesondere weniger als 15 µm, aufgetragen wird. Hiebei können Schichtdicken bis 50 µm oder gegebenenfalls mehr vorgesehen sein.

Darüber hinaus wird im vorliegenden Zusammenhang bevorzugt vorgeschlagen, dass die miteinander zu verbindenden Materialschichten durch einen Laminierprozeß verbunden werden, wobei durch die oben erwähnten Materialeigenschaften des ein Anhaften verhindernden Materials, beispielsweise im Hinblick auf den Schmelzpunkt des Wachses des ein Anhaften verhindernden Materials sowie den Siedepunkt des in diesem Material enthaltenen Lösungsmittels spezielle Erfordernisse insbesondere im Zusammenhang mit der Herstellung einer mehrlagigen Leiterplatte und der im Rahmen der Herstellung einer derartigen mehrlagigen Leiterplatte eingesetzten Materialien berücksichtigt werden können.

Für eine besonders zuverlässige und einfache Entfernung bzw. Lösung des nach der Verbindung der miteinander zu verbindenden flächigen Materialschichten zu entfernenden Teilbereichs wird darüber hinaus vorgeschlagen, dass Randbereiche des zu entfernenden Teilbereichs durch ein Fräsen, Ritzen, Schneiden, insbesondere Laserschneiden definiert und/oder entfernt werden, wie dies einer weiters bevorzugten Ausführungsform des erfindungsgemäßen Verfahrens entspricht. Ein derartiges Fräsen, Ritzen, Schneiden oder dgl. kann in Anpassung an die miteinander zu verbindenden flächigen Materialien entsprechend genau und zuverlässig durchgeführt werden, wobei selbst bei Verwendung von geringe Dicken bzw. Stärken aufweisenden Materialien, wie beispielsweise im Zusammenhang mit der Herstellung einer mehrlagigen Leiterplatte, eine entsprechend genaue und zuverlässige Durchführung des Trennvorgangs möglich ist. Darüber hinaus sind, wie oben bereits ausgeführt, durch die ein Anhaften verhindernde Materialschicht die Anforderungen an die hiefür einzuhaltenden Toleranzen entsprechend geringer.

Es wird somit eine mehrlagige Struktur mit einer einfachen Verbindung zwischen wenigstens zwei im wesentlichen flächigen Materialschichten einer mehrlagigen Leiterplatte zur Verfügung gestellt, wobei eine nachträgliche Entfernung eines zu entfernenden Teilbereichs durch das Vorsehen und einfaches Aufbringen eines ein Anhaften verhindernden Materials bereitstellbar ist. Darüber hinaus läßt sich eine verbesserte Ausrichtung bzw. Registrierung der miteinander zu verbindenden im wesentlichen flächigen Materialschichten zur Verfügung stellen.

Zur einfachen Ausbildung der Freistellung im Bereich des nachträglich zu entfernenden Teilbereichs miteinander zu verbindenden im wesentlichen flächigen Materialschichten ist vorgesehen, dass das ein Anhaften verhindernde Material von einer Wachspaste gebildet ist.

Wie bereits mehrfach ausgeführt, wird darüber hinaus erfindungsgemäß vorgeschlagen, dass das erfindungsgemäße Verfahren oder eine bevorzugte Ausführungsform davon zur Herstellung einer mehrlagigen Leiterplatte verwendet wird bzw. werden.

Insbesondere im Zusammenhang mit einer derartigen erfindungsgemäßen Verwendung wird darüber hinaus bevorzugt vorgeschlagen, das erfindungsgemäße Verfahren zur Erzeugung von Hohlräumen, insbesondere dreidimensionalen Hohlräumen bzw. Kavitäten in einer Leiterplatte zu verwenden.

Weitere bevorzugte Verwendungsmöglichkeiten des erfindungsgemäßen Verfahrens liegen in einer Erzeugung wenigstens eines Kanals in einer Leiterplatte, einer Freistellung zur Erzeugung von Hohlräumen, insbesondere dreidimensionalen Hohlräumen bzw. Kavitäten in einer Leiterplatte, einer Herstellung von abgesetzten und/oder stufenförmig ausgebildeten Teilbereichen einer Leiterplatte, einer Freistellung wenigstens eines Elements, insbesondere Registrierelements im Inneren bzw. in Innenlagen einer mehrlagigen Leiterplatte und/oder einer Herstellung einer starr-flexiblen Leiterplatte.

Die Erfindung wird nachfolgend anhand von in der beiliegenden Zeichnung schematisch dargestellten Ausführungsbeispielen des erfindungsgemäßen Verfahrens zur Herstellung einer mehrlagigen Struktur näher erläutert.

In dieser zeigen:
Fig. 1 einen schematischen Schnitt durch eine erste Ausführungsform einer flächigen Materialschicht einer erfindungsgemäß herzustellenden mehrlagigen Struktur in Form eines starren Bereichs einer starr-flexiblen Leiterplatte als einer mehrlagigen Struktur;
Fig. 2 in einer zu Fig. 1 ähnlichen Darstellung einen Schnitt durch den starren Bereich der starr-flexiblen Leiterplatte, wobei Fräskanten im Bereich einer nachfolgenden Durchtrennung des zu entfernenden Teilbereichs des starren Bereichs vorgesehen sind;
Fig. 3 in einer zu Fig. 1 und 2 ähnlichen Darstellung den Schnitt durch den starren Bereich der starr-flexiblen Leiterplatte, wobei im Bereich der nachfolgenden Durchtrennung sowie der Fräskanten zur Ausbildung einer Freistellung zur Verhinderung einer unmittelbaren Verbindung zwischen den von dem starren Bereich und dem flexiblen Bereich der Leiterplatte gebildeten im wesentlichen flächigen Materialschichten ein ein Anhaften verhinderndes Material vorgesehen bzw. aufgebracht ist;
Fig. 4 einen zu den vorangehenden Figuren wiederum ähnlichen Schnitt, wobei eine Schicht aus nicht-leitendem Material bzw. einem Dielektrikum und ein flexibler Bereich der starr-flexiblen Leiterplatte als zweite im wesentlichen flächige Materialschicht auf dem starren Bereich der ersten Materialschicht angeordnet bzw. festgelegt sind;
Fig. 5 in einem wiederum ähnlichen Schnitt die erfindungsgemäß herzustellende, mehrlagige Struktur in Form der starr-flexiblen Leiterplatte nach einer Durchtrennung des starren Bereichs;
Fig. 6 schematisch einen Schnitt durch eine abgewandelte Ausführungsform einer im wesentlichen flächigen Materialschicht einer Leiterplatte als eine gemäß dem erfindungsgemäßen Verfahren herzustellende, mehrlagige Struktur;
Fig. 7 einen schematischen Schnitt durch die in Fig. 6 dargestellte flächige Materialschicht, wobei eine Schicht aus einem ein Anhaften verhinderndes Material aufgebracht ist bzw. wird;
Fig. 8 einen schematischen Schnitt durch die in Fig. 6 und 7 dargestellte flächige Materialschicht, welche mit wenigstens einer weiteren flächigen Materialschicht zur Herstellung einer mehrlagigen Leiterplatte als einer mehrlagigen Struktur verbunden ist bzw. wird;
Fig. 9 in einer zu Fig. 8 ähnlichen Darstellung einen schematischen Schnitt durch den nachträglich zu entfernenden Teilbereich der mehrlagigen Struktur, welcher durch ein Schneiden begrenzt bzw. definiert ist; und
Fig. 10 eine Darstellung ähnlich zu Fig. 9 ist, wobei der bei der Darstellung gemäß Fig. 9 geschnittene bzw. begrenzte Teilbereich entfernt wird.

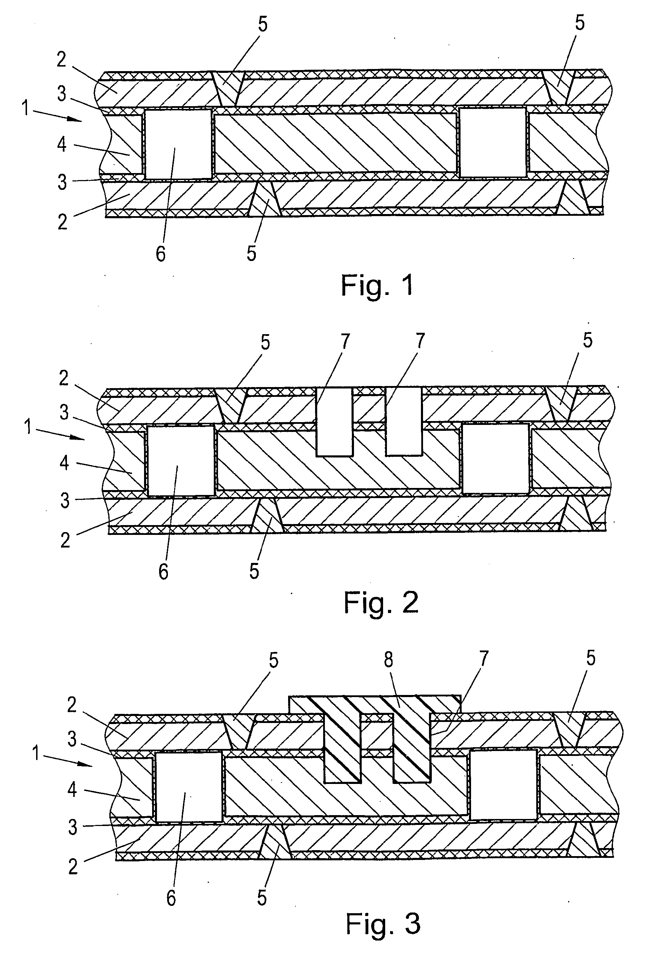

Eine erste Ausführungsform einer erfindungsgemäß herzustellenden mehrlagigen Struktur, welche unter Einsatz des erfindungsgemäßen Verfahrens in Form einer starr-flexiblen Leiterplatte hergestellt wird, wird unter Bezugnahme auf Fig. 1 bis 5 beschrieben.

In Fig. 1 ist eine schematische Darstellung eines starren, mehrlagigen Bereichs 1 als eine erste im wesentlichen flächige Materialschicht einer in weiterer Folge herzustellenden, starr-flexiblen Leiterplatte als einer mehrlagigen Struktur gezeigt. Hiebei sind einzelne Metall- bzw. Kupferschichten 2 beispielsweise durch isolierende bzw. Prepreg-Schichten 3 und einen Kern 4 getrennt. Verbindungen zwischen einzelnen Kupferschichten 2 sind über Mikrovias 5 sowie Durchtrittsöffnungen 6 angedeutet.

Zur Herstellung einer starr-flexiblen Leiterplatte werden im Bereich einer nachfolgenden Durchtrennung des starren, mehrlagigen Bereichs 1 der herzustellenden, starr-flexiblen Leiterplatte Fräskanten 7 ausgebildet, wie dies in Fig. 2 angedeutet ist.

Zur Erzielung einer Freistellung bzw. Verhinderung einer unmittelbaren Verbindung zwischen dem in weiterer Folge zu durchtrennenden, starren Bereich 1 der Leiterplatte und einer zur Verbindung mit einem flexiblen Bereich als zweiter im wesentlichen flächiger Materialschicht der Leiterplatte vorzusehenden und anzuordnenden Schicht aus nicht-leitendem Material oder einem Dielektrikum wird nachträglich an die Ausbildung der Fräskanten 7 in der in Fig. 1 bis 5 gezeigten Ausführungsform ein ein derartiges Anhaften verhinderndes Material 8 im Bereich der nachfolgenden Durchtrennung und in den durch die Fräskanten 7 ausgebildeten Rillen bzw. Nuten angeordnet. Das ein Anhaften verhindernde Material kann beispielsweise von einer wachsartigen Paste 8 gebildet sein, wobei eine derartige wachsartige Paste 8 in einfachen Verfahrensschritten, beispielsweise durch ein Druckverfahren, insbesondere durch Siebdruck oder Schablonendruck, im Bereich der nachfolgenden Durchtrennung sowie in die Fräskanten 7 aufgetragen bzw. eingebracht wird. Abhängig von dem eingesetzten Material 8 bzw. der wachsartigen Paste kann nachfolgend auf das Aufbringen des Materials bzw. der Paste 8 ein Trocknungs- und/oder Härtungsverfahren vorgesehen sein.

Das Material bzw. die Paste 8 kann hiebei in Form einer Mikrodispersion in polaren oder unpolaren, organischen Lösungsmitteln aufgebracht werden. Darüber hinaus ist für eine einfache Verarbeitbarkeit und zur einfachen Handhabbarkeit vorgesehen, daß die Paste 8 beispielsweise von Polyethylenwachsen, Polypropylenwachsen, auf Teflon basierenden Wachsen und/oder Mischungen davon gebildet ist.

Zur weiteren Unterstützung der Verarbeitbarkeit kann darüber hinaus vorgesehen sein, daß die Paste 8 mit anorganischen und/oder organischen Füllstoffen und/oder Additiven versehen ist.

Zur Erzielung entsprechend geringer Schichtdicken bzw. Gesamtstärken der herzustellenden, starr-flexiblen Leiterplatte ist darüber hinaus vorgesehen, daß die Paste bzw. das ein Anhaften verhindernde Material 8 mit einer Schichtstärke von weniger als 25 µm, insbesondere weniger als 20 µm, im Bereich der nachfolgenden Durchtrennung aufgebracht wird.

Während in der in Fig. 1 bis 5 dargestellten Ausführungsform eine Ausbildung der Fräskanten 7 vor dem Aufbringen des ein Anhaften verhindernden Materials bzw. der Paste 8 vorgesehen ist, kann alternativ die Paste 8 im Bereich der nachfolgenden Durchtrennung des starren, insbesondere mehrlagigen Bereichs der Leiterplatte aufgebracht werden, wonach anschließend die Fräskanten 7 das aufgebrachte Material 8 durchdringen.

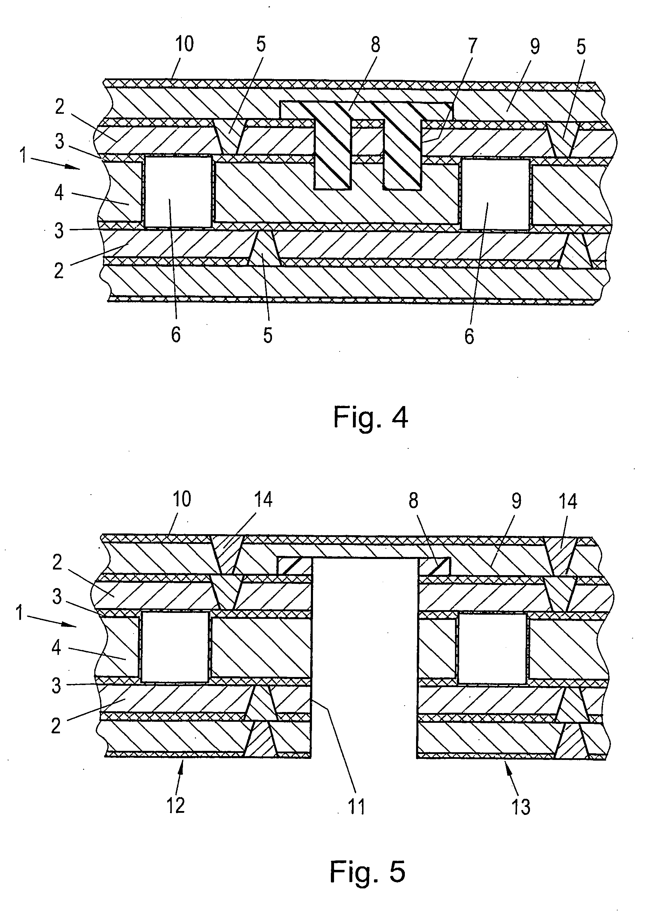

Wie in Fig. 4 gezeigt, erfolgt nach einem Aufbringen des ein Anhaften verhindernden Materials bzw. der Wachspaste 8 im Bereich der nachfolgenden Durchtrennung sowie der Fräskanten 7 eine Aufbringung bzw. Anordnung einer Verbindungsschicht 9 aus nicht-leitendem Material oder einem Dielektrikum, wobei diese Verbindungsschicht 9 beispielsweise von einer an sich bekannten Folie, beispielsweise einem Prepreg oder einer RCC-Folie, oder auch von einem flüssigen Dielektrikum gebildet sein kann. Anschließend an die Schicht 9 aus nicht-leitendem Material bzw. einem Dielektrikum ist ein flexibler Teilbereich 10 der herzustellenden, starr-flexiblen Leiterplatte angedeutet, wobei der flexible Bereich 10 der herzustellenden, starr-flexiblen Leiterplatte ebenso wie der starre Bereich 1 mehrlagig ausgebildet sein kann.

Durch die Anordnung des ein Anhaften verhindernden Materials 8 bzw. der wachsartigen Paste kann für die anzuordnende Schicht 9 aus nicht-leitendem Material oder einem Dielektrikum auf eine Vorkonfektionierung und/oder Formatierung insbesondere im Bereich der nachfolgenden Durchtrennung im Bereich der Fräskanten 7 verzichtet werden, so daß Vorbereitungsschritte für die anzuordnende Schicht 9 aus nicht-leitendem Material oder einem Dielektrikum vereinfacht bzw. verringert werden können.

Durch das Vorsehen des freigestellten Bereichs im Bereich der Aufbringung des Materials 8 auf dem starren Bereich 1 der herzustellenden, starr-flexiblen Leiterplatte kann darüber hinaus mit geringeren Schichtstärken der Schicht 9 das Auslangen gefunden werden, deren Dicke beispielsweise mit weniger als 50 µm, insbesondere 40 µm oder weniger, gewählt wird. Durch Vorsehen derartiger geringer Schichtdicken der zwischen dem starren Bereich 1 und dem flexiblen Bereich 10 der herzustellenden, starr-flexiblen Leiterplatte anzuordnenden Schicht aus nicht-leitendem Material kann nicht nur eine Verringerung der Gesamtdicke der herzustellenden, starr-flexiblen Leiterplatte unterstützt werden, sondern es kann auch die Positionier- sowie Registriergenauigkeit der miteinander zu verbindenden Bereiche und von nachfolgenden Durchtrittsöffnungen bzw. Mikrovias erhöht werden.

In Fig. 5 ist ein Schnitt durch die aus dem starren Bereich 1 und dem flexiblen Bereich 10 gebildete, starr-flexible Leiterplatte als mehrlagige Struktur dargestellt, wobei im Bereich der Fräskanten 7 eine Durchtrennung 11 zwischen den nunmehr voneinander getrennten, starren Teilbereichen 12 und 13 vorgenommen wurde. Diese Durchtrennung 11 stellt hiebei einen nach der Verbindung der flächigen Materialschichten nachträglich zu entfernenden Teilbereich dar. Darüber hinaus ist angedeutet, daß eine Verbindung zwischen dem flexiblen Bereich 10 der Leiterplatte und den nunmehr voneinander getrennten, starren Teilbereichen 12 und 13 durch zusätzliche Mikrovias bzw. Durchtrittsöffnungen 14 erzielbar ist.

Wie aus der Darstellung gemäß Fig. 5 weiters ersichtlich, können ohne besondere Berücksichtigung bzw. ohne Einhaltung von sehr genauen Toleranzen betreffend die Schnittiefe der Durchtrennung bzw. des zu entfernenden Teilbereichs 11 durch Vorsehen des eine Verbindung freistellenden bzw. verhindernden Bereichs durch Aufbringen des ein Anhaften verhindernden Materials 8 auch die Herstellung der Durchtrennung und somit nachfolgende Verfahrensschritte vereinfacht werden.

Durch entsprechende Wahl des ein Anhaften verhindernden Materials bzw. der wachsartigen Paste 8 als auch der zwischen dem starren Bereich 1 bzw. den nachfolgend voneinander getrennten, starren Bereichen 12 und 13 und dem flexiblen Bereich 10 der Leiterplatte anzuordnenden Schicht 9 aus nicht-leitendem Material oder einem Dielektrikum können weiters gesetzlich vorgeschriebene Beschränkungen bei der Verwendung bestimmter, gefährlicher Stoffe in Elektro- und Elektronikgeräten in einfacher Weise berücksichtigt werden.

Durch Vorsehen der Freistellung durch Aufbringen eines ein Anhaften verhindernden Materials bzw. einer Wachspaste 8 kann somit mit vereinfachten Verfahrensschritten insbesondere bei der Vorbereitung bzw. Herstellung der zwischen dem flexiblen Bereich 10 und dem starren Bereich 1 anzuordnenden Schicht 9 als auch nachfolgenden Verfahrensschritten bei der Durchtrennung das Auslangen gefunden werden.

Durch die Verwendung von geringen Schichtstärken für die Verbindung des flexiblen Bereichs 10 sowie des starren Bereichs 1 bzw. der voneinander getrennten, starren Bereiche 12 und 13 und der dadurch erzielbaren, geringen Schichtstärke sowie der daraus resultierenden Verbesserungen der Registriergenauigkeit, wird es darüber hinaus möglich, Leiterplatten mit flexiblen Lagen 10 für hochkomplexe Bauteile auch in großen Formaten, beispielsweise im Produktionsformat von HDI-Leiterplatten von mehr als 18 x 24 Zoll, zur Verfügung zu stellen.

Die in Fig. 1 bis 5 dargestellte Ausführungsform einer mehrlagigen, starren Leiterplatte bzw. eines starren Bereichs 1 der Leiterplatte stellt zu Illustrationszwecken lediglich ein vereinfachtes Beispiel einer derartigen mehrlagigen Leiterplatte als einer mehrlagigen Struktur dar, wobei eine größere Anzahl bzw. Vielzahl von insbesondere leitenden Schichten 2 als auch eine Kontaktierung über Mikrovias 5 bzw. Durchtrittsöffnungen 6 bzw. 14 entsprechend der gewünschten Komplexität des herzustellenden Bauteils Verwendung finden kann.

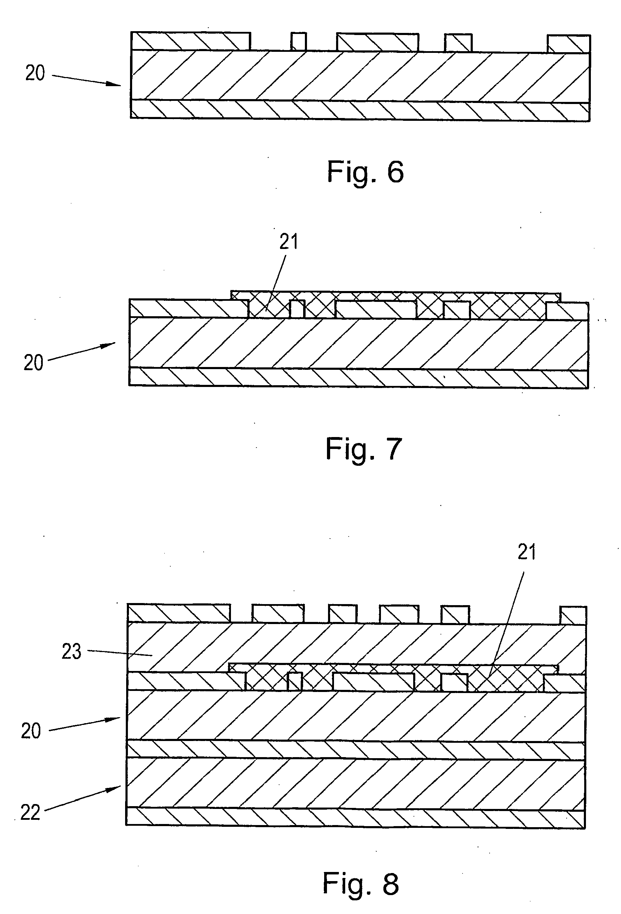

Bei dem in Fig. 6 bis 10 gezeigten Ausführungsbeispiel einer abgewandelten, mehrlagigen Struktur wiederum in Form einer herzustellenden, mehrlagigen Leiterplatte ist mit 20 allgemein ein strukturierter Kern einer derartigen Leiterplatte bezeichnet, wobei dieser Kern 20 aus mehreren Lagen bzw. Schichten besteht, wobei insbesondere die in Fig. 6 dargestellte obere Lage bzw. Schicht entsprechend strukturiert ist.

Der eine im wesentlichen flächige Materialschicht darstellende Kern 20 aus einer oder mehreren Läge(n) wird in weiterer Folge, wie dies in Fig. 7 gezeigt ist, für eine Verbindung mit weiteren Schichten bzw. Lagen als zusätzliche im wesentlichen flächige Materialschichten in einem Teilbereich mit einem ein Anhaften verhindernden Material 21 versehen, welches beispielsweise durch ein Siebdrucken aufgebracht wird.

Nachfolgend auf die in Fig. 7 gezeigte Aufbringung des ein Anhaften verhindernden Materials 21 auf die von dem Kern 20 gebildete, im wesentlichen flächige Materialschicht erfolgt eine Verbindung in an sich bekannter Weise beispielsweise durch einen Laminiervorgang des flächigen Kerns 20 mit einer Vielzahl von wiederum im wesentlichen flächigen Materialschichten 22 und 23, wobei auch in Fig. 8 der mit dem ein Anhaften verhindernden Material versehene Teilbereich mit 21 bezeichnet ist. Die in Fig. 8 dargestellte flächige Materialschicht 23 kann wiederum insbesondere an ihrer Oberseite entsprechend strukturiert ausgebildet sein.

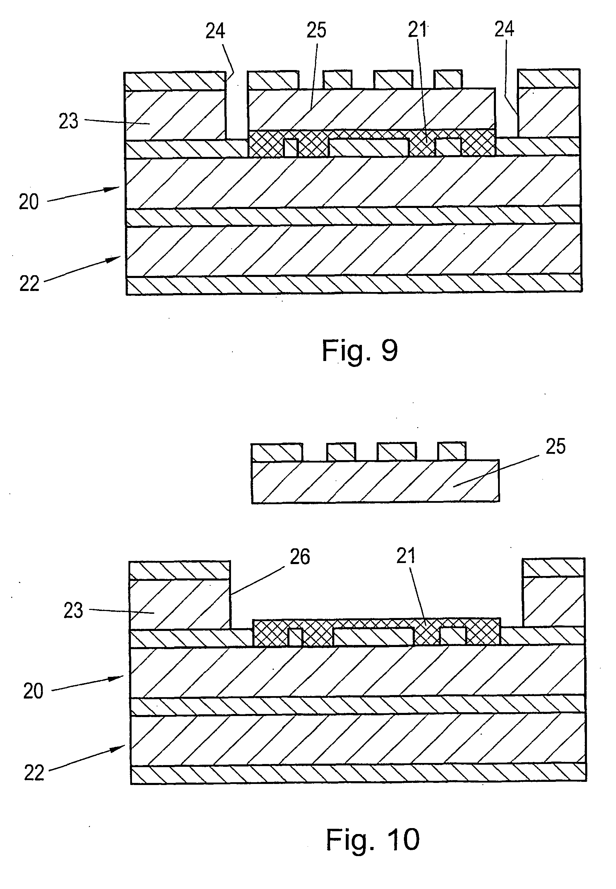

Nach dem in Fig. 8 dargestellten Verbindungsvorgang zwischen der Mehrzahl von im wesentlichen flächigen Materialschichten 20, 22 und 23 erfolgt, wie dies aus Fig. 9 ersichtlich ist, beispielsweise durch ein Schneiden, insbesondere ein Laserschneiden unter Ausbildung von Schnittlinien bzw. Vertiefungen 24 eine Begrenzung bzw. Definition eines Teilbereichs 25 der im wesentlichen flächigen Materialschicht 23. Durch das unterhalb des zu entfernenden Teilbereichs 25 vorgesehene, ein Anhaften verhindernde Material 21 gelingt in einfacher Weise nach Ausbildung der Schnittlinie bzw. begrenzenden Vertiefungen 24 eine einfache und zuverlässige Entfernung des Teilbereichs 25, wie dies in Fig. 10 dargestellt bzw. angedeutet ist.

In der in Fig. 6 bis 10 dargestellten Ausführungsform sind zwischen den einzelnen im wesentlichen, im wesentlichen flächigen Materialschichten zusätzliche Schichten angedeutet, welche für sich gesehen im Zusammenhang mit der Herstellung einer mehrlagigen Leiterplatte bekannt sind und somit nicht im Detail erörtert werden.

Auch bei der Ausführungsform gemäß Fig. 6 bis 10 ist klar ersichtlich, daß durch ein Vorsehen einer Freistellung im Zusammenhang mit einer Verbindung von im wesentlichen flächigen Materialien bzw. Materialschichten 20, 22 und 23 durch ein Aufbringen eines beispielsweise von einer Wachspaste gebildeten, ein Anhaften verhindernden Materials 21 in weiterer Folge eine einfache und zuverlässige Entfernung von Teilbereichen 25 wenigstens einer miteinander zu verbindenden, im wesentlichen flächigen Schicht 23 ermöglicht wird.

Anstelle des in Fig. 9 dargestellten bzw. angeführten Schneidens, beispielsweise Laserschneidens, kann beispielsweise ein Fräsen, wie dies in der Ausführungsform gemäß Fig. 1 bis 5 gezeigt ist, oder ein Ritzen oder ähnliches Durchtrennen der wenigstens einen Materialschicht 23 vorgenommen werden.

Bei der Ausführungsform gemäß Fig. 6 bis 10 ist ersichtlich, daß durch eine Entfernung des Teilbereichs 25 beispielsweise ein Hohlraum bzw. eine Kavität 26, insbesondere ein dreidimensionaler Hohlraum in Teilbereichen bzw. einzelnen Schichten bzw. Lagen einer mehrlagigen Leiterplatte hergestellt werden kann.

Ein derartiger Hohlraum 26 durch Entfernung des Teilbereichs bzw. Elements 25 kann darüber hinaus zur nachfolgenden Anordnung von getrennten Elementen in Innenbereichen bzw. inneren Lagen einer mehrlagigen Leiterplatte verwendet bzw. eingesetzt werden.

Darüber hinaus läßt sich durch eine Entfernung von Teilbereichen eine Leiterplatte mit abgesetzten und/oder stufenförmig ausgebildeten Teilbereichen für spezielle Anwendungszwecke zur Verfügung stellen.

Das ein Anhaften verhindernde Material 8 bzw. 21 kann neben den in den in den obigen Ausführungsformen genannten Materialien beispielsweise auch durch Kohlenwasserstoffwachse und -öle, Wachse und Öle auf Basis von Polyethylen- oder Polypropylenverbindungen, Wachse und Öle auf Basis von organischen Polyfluorverbindungen, Estern von Fettsäuren und Alkoholen oder Polyamiden, siliziumorganische Verbindungen und/oder Mischungen gebildet werden.

Anstelle der Ausbildung einer mehrlagigen Struktur einer mehrlagigen Leiterplatte, wie dies in den obigen Ausführungsbeispielen gezeigt ist, können derartige, mehrschichtige Strukturen auch aus von den Materialien zur Herstellung einer Leiterplatte unterschiedlichen Materialien, wie beispielsweise Folien oder blatt- bzw. plattenförmigen Materialen gebildet werden. Nach bzw. bei einem einfachen und zuverlässigen Verbinden von im wesentlichen flächigen Materialschichten, wobei für die Verbindungsschicht auf eine Vorkonfektionierung bzw. Formatierung beispielsweise von Klebe- bzw. Verbindungsfolien verzichtet wird, können nachfolgend auf eine derartige vereinfachte Verbindung von im wesentlichen vollflächigen Materialschichten Teilbereiche einfach und zuverlässig durch das Vorsehen bzw. Aufbringen des ein Anhaften verhindernden Materials 8 bzw. 21 entfernt werden.

Zusätzlich zu den in den obigen Ausführungsbeispielen genannten Druckverfahren, beispielsweise Siebdruckverfahren, zur Aufbringung des ein Anhaften verhindernden Materials 8 bzw. 21 können beispielsweise insbesondere in Abhängigkeit von der Beschaffenheit des ein Anhaften verhindernden Materials, beispielsweise ein Offsetdruck, Flexodruck, Tampondruck, Tintenstrahldruck oder dgl. vorgesehen sein bzw. angewandt werden.

Für eine zuverlässige Trennung bzw. Entfernung des nachträglich zu entfernenden Bereichs 11 bzw. 25 ist insbesondere im Zusammenhang mit der Verwendung des ein Anhaften verhindernden Materials 8 bzw. 21, insbesondere in Form einer wachsartigen Paste darauf zu achten, daß dieses ein Anhaften verhindernde Material einen entsprechenden Polaritätsunterschied sowie eine Unverträglichkeit zu der bzw. den anschließenden, im wesentlichen flächigen Materialschicht(en) aufweist.

Im Zusammenhang mit der Herstellung einer Leiterplatte sind somit beispielsweise Polaritätsunterschiede und Unverträglichkeiten mit Epoxidharz, Phenolharzen und Kupfer als häufig eingesetzten Schichten einer mehrlagigen Leiterplatte zu beachten.

Durch die erfindungsgemäße Möglichkeit einer strukturierten Aufbringung des ein Anhaften verhindernden Materials 8 bzw. 21 lassen sich somit in einfacher Weise nachfolgende Verfahrensschritte insbesondere im Zusammenhang mit einer Entfernung von nachträglich entfernbaren Teilbereichen einer mehrlagigen Struktur vereinfachen.

Durch Einsatz einer beispielsweise durch eine einfache Drucktechnik aufbringbaren Schicht bzw. Lage aus einem ein Anhaften verhindernden Material 8 bzw. 21 kann auf im Stand der Technik vorgesehene Formatierungs- bzw. Konfektionierungstechniken beispielsweise für Trennfolien verzichtet werden.

Darüber hinaus ist es bei Einsatz einer wachsartigen Paste für das ein Anhaften verhindernde Material 8 bzw. 21 vorteilhaft, daß nach einer Entfernung beispielsweise des Teilbereichs 11 bzw. 25 gegebenenfalls verbleibende Rückstände des ein Anhaften verhindernden Materials 8 bzw. 21 in einfacher Weise und zuverlässig wiederum entfernt werden können.

Insbesondere im Zusammenhang mit der Herstellung bzw. Be- bzw. Verarbeitung von Leiterplatten wird es durch das Freistellen bzw. Vorsehen eines ein Anhaften verhindernden Materials 8 bis 21 möglich, durch eine beispielsweise lokale Dickenreduktion einen Raum 26 für zusätzliche Bauelemente zur Verfügung zu stellen, wie dies oben erwähnt wurde. Durch eine derartige Bereitstellung eines Raums 26 insbesondere bzw. im wesentlichen im Inneren einer derartigen mehrlagigen Leiterplatte wird darüber hinaus ermöglicht, die gesamte Dicke einer derartigen mehrlagigen Leiterplatte durch ein Einbetten derartiger Bauteile zu verringern, so daß Anforderungen im Hinblick auf eine Miniaturisierung von Leiterplatten Rechnung getragen werden kann.

Durch eine lokale Dickenreduktion können die im Bereich des entfernten Teilbereichs 25 anzuordnenden zusätzlichen Bauelemente insbesondere nach einer Entfernung des gegebenenfalls verbliebenden, ein Anhaften verhindernden Materials 21, wie dies in Fig. 10 angedeutet ist, unmittelbar am Boden einer derartigen Ausnehmung bzw. eines derartigen Hohlraums 26 beispielsweise kontaktiert werden. Hiebei können in einfacher Weise beispielsweise bei der in Fig. 6 zur Verfügung gestellten Materialschicht 20 entsprechende Kontaktelemente bzw. leitfähige Strukturen im Bereich des nachträglich herzustellenden Hohlraums 26, wie dies in Fig. 10 dargestellt ist, vorgesehen bzw. zur Verfügung gestellt werden.

Wie oben bereits angeführt, können durch die nachträgliche Entfernung von Teilbereichen 25 unter Ausbildung von Hohlräumen 26 auch entsprechende dreidimensional offene oder gegebenenfalls geschlossene Hohlräume zur Verfügung gestellt werden, wobei in diesem Zusammenhang beispielsweise ausgehend von dem in Fig. 10 dargestellten Zustand weitere Lagen einer mehrlagigen Leiterplatte zur Verfügung gestellt werden können.

Darüber hinaus läßt sich durch entsprechende Wahl bzw. Anordnung des eine Anhaftung verhindernden Materials 8 bzw. 21 eine Ausbildung von Hohlräumen 26 über mehrere Lagen bzw. Schichten einer derartigen mehrlagigen Leiterstruktur zur Verfügung stellen, wie dies beispielsweise bei der ersten Ausführungsform in Fig. 5 angedeutet ist.

Somit läßt sich im Zusammenhang mit der Herstellung von Leiterplatten durch Entfernen von Teilbereichen 25 beispielsweise auch eine entsprechend vereinfachte Freistellung von Registrierelementen zur Verfügung stellen.

Eine Ausbildung von stufenförmigen bzw. abgesetzten Teilbereichen ermöglicht beispielsweise die Herstellung von verschachtelten bzw. sich überschneidenden Bereichen einer mehrlagigen Leiterplatte.

Durch eine Entfernung von Teilbereichen durch Vorsehen des ein Anhaften verhindernden Materials 8 bzw. 21 ist es darüber hinaus möglich, beispielsweise eine Reparaturmöglichkeit bestehender bzw. bereits bestückter Leiterplatten mit eingebetteten Bauteilen zur Verfügung zu stellen, falls beispielsweise vorsorglich im Bereich von gegebenenfalls einer hohen Ausfalls- bzw. Beschädigungsrate ausgesetzten Beauelementen entsprechend ein ein Anhaften verhinderndes Material vorgesehen wird, so daß nach einem Schadhaftwerden eines derartigen Bauelements durch Entfernen eines Teilbereichs eine Leiterplatte repariert werden kann, und nicht vollständig ersetzt werden muß, so daß ein einfacher Austausch von Bauteilen möglich wird und eine mehrlagige Struktur, welche aus wenigstens zwei miteinander zu verbindenden, im wesentlichen flächigen Materialschichten besteht, einfach zur Verfügung gestellt werden kann.

## Patentansprüche

1. Verfahren zum Entfernen eines Teilbereichs einer im wesentlichen flächigen Materialschicht (2), welche in einem Verbindungsvorgang mit wenigstens einer weiteren, im wesentlichen flächigen Materialschicht (9) verbunden wird, wobei im Bereich der nachfolgenden Entfernung des Teilbereichs (11, 25) ein von einer unmittelbaren Verbindung zwischen den Materialschichten (2, 9; 20, 23) freigestellter Bereich durch Aufbringen eines ein Anhaften der zu verbindenden Materialschichten verhindernden Materials (8, 21) vorgesehen wird, wobei die miteinander zu verbindenden, im wesentlichen flächigen Materialschichten von Schichten bzw. Lagen (2, 4, 9; 20, 22, 23) einer mehrlagigen Leiterplatte gebildet werden, **dadurch gekennzeichnet, dass** das ein Anhaften verhindernde Material einen derart hohen Erweichungspunkt bzw. Fliesspunkt aufweist, so dass es während eines Laminiervorgangs zu einem Härten der darüber hinaus eingesetzten Kleberlagen kommt und es bei weiterer Erhöhung der Temperatur während des Verbindungsvorgangs bzw. Pressvorgangs zu einer Verflüssigung des ein Anhaften verhindernden Materials kommt, und dass das ein Anhaften verhindernde Material (8, 21) als wachsartige Paste in Form einer Dispersion in einem Lösungsmittel aufgebracht wird und wobei das ein Anhaften verhindernde Material weiter eine Trennkomponente und ein Bindemittel enthält.

2. Verfahren nach Anspruch 1, **dadurch gekennzeichnet, dass** das ein Anhaften verhindernde Material (8, 21) durch ein Druckverfahren, insbesondere durch Siebdruck, Schablonendruck, Offsetdruck, Flexodruck, Tampondruck, Tintenstrahldruck oder dgl. aufgebracht wird und gegebenenfalls einem nachfolgenden Trocknungs- und/oder Härtverfahren unterworfen wird.

3. Verfahren nach Anspruch 1 oder 2, **dadurch gekennzeichnet, dass** das ein Anhaften verhindernde Material (8, 21) Kohlenwasserstoffwachse und -öle, Wachse und Öle auf Basis von Polyethylen- oder Polypropylenverbindungen, Wachse und Öle auf Basis von organischen Polyfluorverbindungen, Estern von Fettsäuren und Alkoholen oder Polyamiden, siliziumorganische Verbindungen und/oder Mischungen davon enthält.

4. Verfahren nach einem der Ansprüche 1 bis 3, **dadurch gekennzeichnet, dass** das ein Anhaften verhindernde Material (8, 21) in einer Schichtstärke von weniger als 25 µm, insbesondere weniger als 15 µm, aufgetragen wird.

5. Verfahren nach einem der Ansprüche 1 bis 4, **dadurch gekennzeichnet, dass** die miteinander zu verbindenden Materialschichten (2, 4, 9; 20, 22, 23) durch einen Laminierprozeß verbunden werden.

6. Verfahren nach einem der Ansprüche 1 bis 5, **dadurch gekennzeichnet, dass** Randbereiche des zu entfernenden Teilbereichs (11, 25) durch ein Fräsen, Ritzen, Schneiden, insbesondere Laserschneiden definiert und/oder entfernt werden.

7. Verwendung eines Verfahrens nach einem der Ansprüche 1 bis 6 zur Erzeugung von Hohlräumen, insbesondere dreidimensionalen Hohlräumen bzw. Kavitäten in einer Leiterplatte.

8. Verwendung eines Verfahrens nach einem der Ansprüche 1 bis 6 zur Erzeugung wenigstens eines Kanals in einer Leiterplatte.

9. Verwendung eines Verfahrens nach einem der Ansprüche 1 bis 6 zur Freistellung wenigstens eines Elements, insbesondere Registrierelements im Inneren bzw. in Innenlagen einer mehrlagigen Leiterplatte.

10. Verwendung eines Verfahrens nach einem der Ansprüche 1 bis 6 zur Herstellung von abgesetzten und/oder stufenförmig ausgebildeten Teilbereichen einer Leiterplatte.

11. Verwendung eines Verfahrens nach einem der Ansprüche 1 bis 6 zur Herstellung einer starr-flexiblen Leiterplatte.

## Claims

1. A method for removing a subportion or part of a substantially flat or planar material layer (2) which is bonded with at least one further substantially flat or planar material layer (9) in a bonding procedure, wherein, in the region or zone of the subsequent removal of the subportion (11, 25), an area kept free from direct bonding between the material layers (2, 9; 20, 23) is provided by applying a material (8, 21) preventing the adhesion of the material layers to be bonded, wherein the substantially flat material layers to be bonded are formed by layers (2, 4, 9; 20, 22, 23) of a multilayer printed circuit board, **characterized in that** the adhesion-preventing material has such a high softening or melting point resulting in a hardening of any further layers of adhesives being used and resulting in a liquefication of the adhesion-preventing material during a further increase of the temperature during the connecting or pressing process, and **in that** the adhesion-preventing material (8, 21) is applied as a waxy paste as a dispersion in a solvent and wherein the adhesion-preventing material furthermore comprises a separating component and a binder.

2. A method according to claim 1, **characterized in that** the adhesion-preventing material (8, 21) is applied by a printing process and, in particular, screen-printing, stencil-printing, offset printing, flexoprinting, tampon printing, ink-jet printing or the like, and optionally subjected to a subsequent drying and/or curing process.

3. A method according to claim 1 or 2, **characterized in that** the adhesion-preventing material (8, 21) comprises hydrocarbon waxes and oils, waxes and oils based on polyethylene or polypropylene compounds, waxes and oils based on organic polyfluoro compounds, esters of fatty acids and alcohols or polyamides, silicoorganic compounds and/or mixtures thereof.

4. A method according to any one of claims 1 to 3, **characterized in that** the adhesion-preventing material (8, 21) is applied in a layer thickness of less than 25 µm and, in particular, less than 15 µm.

5. A method according to any one of claims 1 to 4, **characterized in that** the material layers (2, 4, 9; 20, 22, 23) to be bonded are bonded by a lamination process.

6. A method according to any one of claims 1 to 5, **characterized in that** edge regions of the subportion (11, 25) to be removed are defined and/or removed by milling, scratching, cutting, in particular laser-cutting.

7. The use of a method according to any one of claims 1 to 6 for the production of cavities, in particular three-dimensional cavities, in a printed circuit board.

8. The use of a method according to any one of claims 1 to 6 for the production of at least one channel in a printed circuit board.

9. The use of a method according to any one of claims 1 to 6 for the non-bonding or exemption of at least one element, in particular registering element, in the interior or within internal layers of a multilayer printed circuit board.

10. The use of a method according to any one of claims 1 to 6 for the production of offset and/or stepped subportions of a printed circuit board.

11. The use of a method according to any one of claims 1 to 6 for the production of a rigid-flexible printed circuit board.

## Revendications

1. Procédé d'élimination d'une zone partielle d'une couche de matériau (2) sensiblement plate, laquelle est reliée au cours d'une procédure de liaison à au moins une autre couche de matériau (9) sensiblement plate, une zone exemptée d'une liaison directe entre les couches de matériau (2, 9 ; 20, 23) par application d'un matériau (8, 21) empêchant une adhérence des couches de matériau à relier étant prévue dans la zone de l'élimination ultérieure de la zone partielle (11, 25), les couches de matériau sensiblement plates et destinées à être reliées les unes aux autres étant formées par des couches (2, 4, 9 ; 20, 22, 23) d'une carte de circuit imprimé multicouche, **caractérisé en ce que** le matériau empêchant une adhérence présente un point de ramollissement ou de fluage si élevé que lorsqu'il se produit un durcissement des couches de colle par ailleurs insérées pendant un processus de laminage et qu'il se produit une liquéfaction du matériau empêchant une adhérence au cours d'une augmentation supplémentaire de la température pendant le processus de liaison ou le processus de compression, et **en ce que** le matériau (8, 21) empêchant une adhérence est appliqué en tant que pâte de type cire sous forme d'une dispersion dans un solvant, et le matériau empêchant une adhérence contient en outre un composant de séparation et un liant.

2. Procédé selon la revendication 1, **caractérisé en ce que** le matériau (8, 21) empêchant une adhérence est appliqué par un procédé d'impression, en particulier par sérigraphie, impression au pochoir, impression offset, flexographie, impression au tampon, impression par jet d'encre ou similaire et est éventuellement soumis par la suite à un procédé de séchage et/ou de durcissement.

3. Procédé selon la revendication 1 ou 2, **caractérisé en ce qu'**un matériau (8, 21) empêchant une adhérence contient des cires et des huiles d'hydrocarbure, des cires et des huiles à base de composés de polyéthylène ou de polypropylène, des cires et des huiles à base de composés polyfluorés organiques, des esters d'acides gras et d'alcools ou des polyamides, des composés de silicium organique et/ou leurs mélanges.

4. Procédé selon l'une quelconque des revendications 1 à 3, **caractérisé en ce que** le matériau (8, 21) empêchant une adhérence est appliqué dans une épaisseur de couche inférieure à 25 µm, en particulier inférieure à 15 µm.

5. Procédé selon l'une quelconque des revendications 1 à 4, **caractérisé en ce que** les couches de matériau (2, 4, 9 ; 20, 22, 23) destinées à être reliées les unes aux autres sont reliées par un processus de laminage.

6. Procédé selon l'une quelconque des revendications 1 à 5, **caractérisé en ce que** les zones de bord de la zone partielle (11, 25) à éliminer sont définies et/ou éliminées par fraisage, incision, découpage, en particulier découpage au laser.

7. Utilisation d'un procédé selon l'une quelconque des revendications 1 à 6 pour produire des cavités, en particulier des cavités tridimensionnelles dans une carte de circuit imprimé.

8. Utilisation d'un procédé selon l'une quelconque des revendications 1 à 6 pour produire au moins un canal dans une carte de circuit imprimé.

9. Utilisation d'un procédé selon l'une quelconque des revendications 1 à 6 pour exempter au moins un élément, en particulier un élément d'enregistrement à l'intérieur ou dans les couches intérieures d'une carte de circuit imprimé multicouche.

10. Utilisation d'un procédé selon l'une quelconque des revendications 1 à 6 pour fabriquer des zones partielles d'une carte de circuit imprimé conçues de façon décalée et/ou en gradin.

11. Utilisation d'un procédé selon l'une quelconque des revendications 1 à 6 pour fabriquer une carte de circuit imprimé rigide-flexible.
